Europäisches Patentamt

European Patent Office

Office européen des brevets

(19)

(11) **EP 0 801 842 B1**

(12) **EUROPÄISCHE PATENTSCHRIFT**

(45) Veröffentlichungstag und Bekanntmachung des Hinweises auf die Patenterteilung:
**23.12.1998 Patentblatt 1998/52**

(21) Anmeldenummer: **95935804.5**

(22) Anmeldetag: **24.10.1995**

(51) Int Cl.6: **H02M 3/335**, H03K 7/08

(86) Internationale Anmeldenummer:
**PCT/DE95/01480**

(87) Internationale Veröffentlichungsnummer:
**WO 96/13893 (09.05.1996 Gazette 1996/21)**

(54) **SCHALTUNGSANORDNUNG ZUR ANSTEUERUNG EINES UMRICHTERS**

CIRCUIT FOR DRIVING A CONVERTER

CIRCUIT POUR LA COMMANDE D'UN CONVERTISSEUR

(84) Benannte Vertragsstaaten:
**AT BE CH DE DK FR GB IT LI NL PT SE**

(30) Priorität: **28.10.1994 DE 4438671**

(43) Veröffentlichungstag der Anmeldung:
**22.10.1997 Patentblatt 1997/43**

(73) Patentinhaber:
• **SIEMENS AKTIENGESELLSCHAFT**
**80333 München (DE)**
• **SGS-THOMSON MICROELECTRONICS GMBH**
**85630 Grasbrunn (DE)**

(72) Erfinder:
• **BRAKUS, Bogdan**
**D-82131 Stockdorf (DE)**
• **ROTH, Heinz-Jürgen**
**D-80469 München (DE)**

(56) Entgegenhaltungen:
**DE-A- 4 105 464**    **GB-A- 2 072 448**
**US-A- 3 831 113**    **US-A- 4 016 498**

EP 0 801 842 B1

**Beschreibung**

Die Erfindung bezieht sich auf eine im Oberbegriff des Patentanspruchs 1 angegebenen Schaltungsanordnung, insbesondere auf eine Schaltungsanordnung zur Steuerung einer Folgefrequenz und Einschaltdauer eines getakteten Schaltumrichters.

Eine Schaltungsanordnung zur Steuerung der Folgefrequenz und Einschaltdauer wurde bereits in der Offenlegungsschrift DE 41 05 464 A1 vorgeschlagen.

Derartige Schaltungsanordnungen stoßen bei höheren Frequenzen an ihre Anwendbarkeitsgrenzen.

Aufgabe der Erfindung ist es, einen Steuerbaustein so auszubilden, das er für hohe Steuerfrequenzen bei einer vergleichsweisen geringen Eigenstromaufnahme geeignet ist.

Gemäß der Erfindung wird ein Umrichter nach dem Oberbegriff des Patentanspruchs zur Lösung dieser Aufgabe in der im kennzeichnenden Teil des Patentanspruchs 1 angegebenen Weise ausgebildet.

Die Erfindung weist neben dem Vorteil, daß für die Schaltungsanordnung ein geringer Platzbedarf benötigt wird, die weiteren Vorteile auf, daß in einem großen Stellbereich, insbesondere für hohe Frequenzen ein geringer Strombedarf sowie eine kontinuierliche Strombegrenzung realisiert werden kann. Die Schaltungsanordnung bringt desweiteren den Vorteil mit sich, daß eine exakte umgekehrte Proportionalität zwischen der Eingangsspannung und den Impulsbreiten des Ausgangssignals gegeben ist.

Die Schaltungsanordnung weist den Vorteil auf, daß die Frequenz und das Impuls/Pause Verhältnis des Ausgangssignals in sehr weiten Bereichen unabhängig voneinander variierbar sind.

Ein weiterer Vorteil der Schaltungsanordnung ist, daß mit Verringerung der Folgefrequenz der Stromverbrauch der angegebenen Schaltungsanordnung abnimmt und sich ein günstiger Wirkungsgrad bei geringer Leistungsanforderung der Sekundärseite ergibt.

Eine weitere Ausgestaltung der Schaltungsanordnung ist, daß diese in einem integrierten Schaltkreis ausführbar ist und sehr wenig externe Komponenten benötigt.

Eine weitere Ausgestaltung der Schaltungsanordnung ist, daß diese temperaturkompensiert ist und im ungesättigten Betrieb arbeitet, wodurch sich ein Betrieb bei hohen Frequenzen mit geringer Verlustleistung und guter Temperaturstabilität ergibt.

Eine weitere Ausgestaltung der Schaltungsanordnung besteht darin, daß ein wirkungsvoller Schutz der Schaltungsanordnung während einer Leitphase über einen Eingangssensor vorhanden ist, der die Einschaltzeit umgekehrt proportional zur Eingangsspannung verkürzt.

Vorteilhafte Ausbildungen der Erfindung sind in den Unteransprüchen angegeben.

Weitere Besonderheiten der Erfindung werden aus der nachfolgenden näheren Erläuterung eines Ausführungsbeispiels anhand von Zeichnungen ersichtlich.

Es zeigen :

| | |
|---|---|
| Fig. 1 | einen bekannten Umrichter, |
| Fig. 2 | dazugehörige Pulsdiagramme, |
| Fig. 3 | eine schematische Darstellung einer Schaltungsanordnung zur Ansteuerung eines Umrichters, |
| Fig. 4 | dazugehörige Pulsdiagramme, |
| Fig. 5 | eine weitere schematische Darstellung, |
| Fig. 6, 7, 8, 9 | eine Detaildarstellung der in Fig. 3 abgebildeten schematischen Darstellung der Schaltungsanordnung, |
| Fig. 10 | einen Spannungsverlauf am Ausgang der Schaltungsanordnung ohne Impulsverkürzung, |
| Fig. 11 | einen Spannungsverlauf am Ausgang der Schaltunganordnung, |
| Fig. 12 | einen Spannungsverlauf am Ausgang der Schaltungsanordnung und |
| Fig. 13 | einen weiteren Spannungsverlauf am Ausgang der Schaltungsanordnung. |

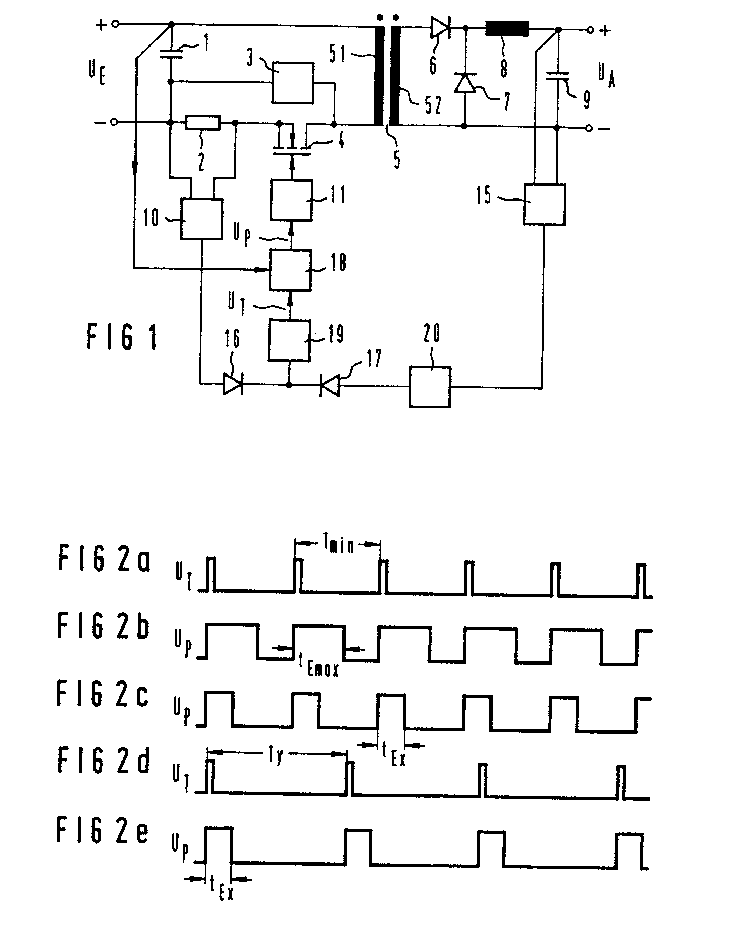

Zum besseren Verständnis der Erfindung wird anhand der Fig. 1 sowie der Fig. 2 die Funktionsweise eines Durchflußumrichters erläutert. Bei dem in Fig. 1 gezeigten Durchflußumrichter liegt die Eingangsspannung UE am Kondensator 1 und die Ausgangsspannung UA am Kondensator 9. Parallel zum Kondensator 1 liegt eine aus der Primärwicklung 51 des Transformators 5, der Drain-Source-Strecke des Feldeffekttransistors 4 und dem Meßwiderstand 2 gebildete Serienschaltung. Parallel zur Serienschaltung aus Meßwiderstand 2 und Drain-Source-Strecke des Feldeffekttransistors 4 liegt die Anordnung 3 zur RCD-Beschaltung. Zwischen der Sekundärwicklung 52 des Übertragers 5 und dem Kondensator 9 liegt die Gleichrichterdiode 6. In einem auf die Gleichrichterdiode 6 folgenden Querzweig ist die Freilaufdiode 7 angeordnet. In einem Längszweig zwischen Freilaufdiode 7 und Kondensator 9 liegt die Drossel 8. Die Steuerelektrode des Feldeffekttransistors 4 ist an einen Treiber 11 angeschlossen. Der Meßwiderstand 2 liegt an einem Stromregler 10, am Ausgang des Umrichters befindet sich ein Spannungsregler 15 sowie ein Optokoppler 20. Der Stromregler 10 und der Optokoppler 20 sind über je eine Diode 16 bzw. 17 an den Eingang eines Oszillators 19 angeschlossen. Der Pulsgenerator 18 liegt mit einem Eingang am Eingang des Umrichters, d.h. an der Eingangsspannung UE. Ein weiterer Eingang ist mit dem spannungsgesteuerten Oszillator 19 verbunden. Über diesen Eingang erhält der Pulsgenerator 18 eine Taktspannung UT mit variabler Frequenz. Der Pulsgenerator 18 erzeugt eine Folge von Impulsen Up, deren Folgefrequenz durch den spannungsgesteuerten Oszillator 19 vorgegeben ist und deren Einschaltdauer umgekehrt proportional zur Eingangsspannung UE ist. Im allgemeinen liefert der Pulsgenerator 18 Pulse Up bestimmter Einschaltdauer tE. Die Wiederholfrequenz wird von dem spannungsgesteuerten Oszillator 19 entsprechend dem Arbeitspunkt des I-Reglers 10 oder des U-Reglers 15 über den Optokoppler 20 eingestellt. Im Grenzfall kann die der minimalen Periodendauer Tmin entsprechende maximale Frequenz durch die minimal realisierbare Einschaltdauer und den gewünschten Tastgrad bestimmt werden:

$$f = \gamma / t_E \qquad (3)$$

Dabei ist f die Wiederholfrequenz des Einschaltimpulses, $\gamma$ der Tastgrad und $t_E$ die Dauer der Einschaltpulse.

Bei einem Einschaltpuls mit einer Dauer $t_E = 0{,}5\ \mu s$ und dem Tastgrad $\gamma = 0{,}5$ ergibt sich eine Frequenz von 1 MHz. Die Dauer des Einschaltpulses hängt von der Eingangsspannung $U_E$ ab. Sie ist umgekehrt proportional der Eingangsspannung

$$t_E \sim 1/U_E \qquad (4)$$

Die Änderung der Eingangsspannung $U_E$ ist bei dem Durchflußumrichter die dominante Störgröße. Beim idealisierten verlustlosen Umrichter gilt die Beziehung:

$$U_A = U_E \cdot \gamma \qquad (5)$$

Bleibt nach Einführung der Bezeichnung (4) das Produkt $U_E . t_E$ konstant, so braucht bei einer Eingangsspannungsanderung die Frequenz nicht geändert zu werden, um die Ausgangsspannung $U_A$ konstant zu halten.

Die in Fig. 2 dargestellten Impulsdiagramme zeigen das prinzipielle Verhalten des Umrichters bei verschiedenen Betriebszuständen.

a) In der Anlaufphase bzw. bei zu geringer Ausgangsspannung stellt der spannungsgesteuerte Oszillator VCO (19) die maximale Frequenz ein. Dies entspricht der minimalen Periodendauer $T_{min}$ der Taktpulse $U_T$.

b) Bei der minimalen Eingangsspannung liefert der Pulsgenerator 18 den Einschaltimpuls $U_p$ mit maximaler Dauer $t_{Emax}$.

c) Eine Erhöhung der Eingangsspannung hat eine Verkürzung der Einschaltzeit auf einen neuen Wert $t_{Ex}$ zur Folge, ohne das sich dabei die Frequenz verändert.

d/e) Die beiden Diagramme zeigen die Frequenzreduzierung bei starker Entlastung oder bei Überlast und unveränderter Eingangsspannung $U_E$. Es stellt sich die längere Periodendauer $T_y$ bei gleichbleibender Einschaltzeit $t_{Ex}$ ein.

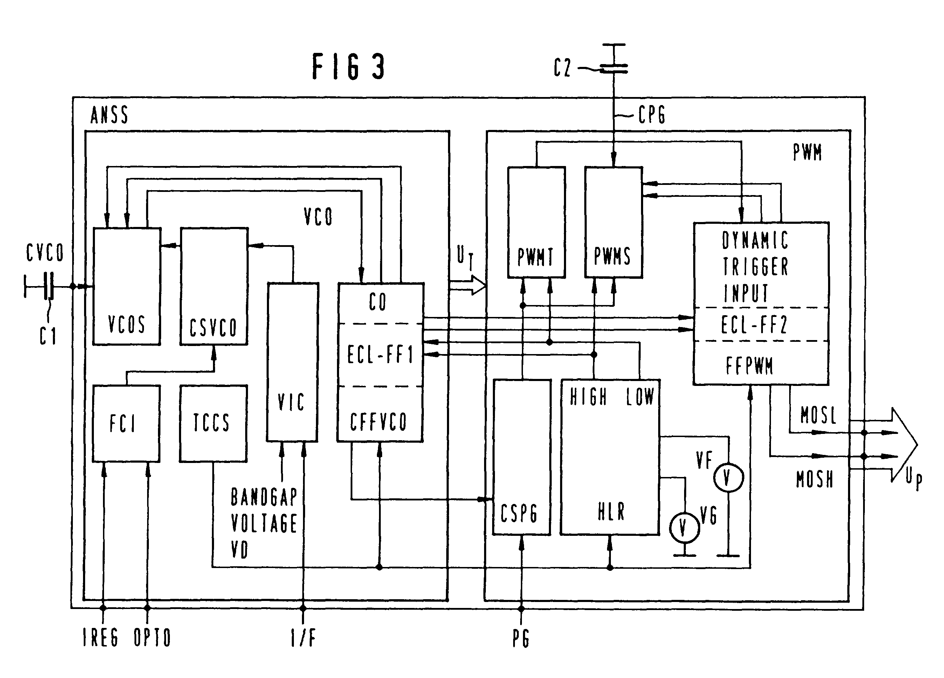

Fig. 3 zeigt eine schematische Darstellung einer Ausgestaltung der erfindungsgemäßen Schaltungsanordnung. Diese Schaltungsanordnung ANSS zur Ansteuerung eines Umrichters setzt sich im wesentlichen aus den in einem Funktionsblock VCO, einen spannungsgesteuerten Oszillator, und den in einem Funktionsblock PWM, einen Pulsweitenmodulator, angeordneten Schaltkreisen zusammen.

Im einzelnen sind im Funktionsblock VCO folgende Schaltkreise:

FCI:      Frequency Control Input,
VCOS:     VCO-Switch,
CSVCO:    Current Source VCO,
TCCS:     Temperature Compensated Current Source,
VIC:      Voltage to Current Converter sowie
CFFVCO:   Komparator CO, ECL-Flip-Flop ECL-FF1.

Im Funktionsblock PWM sind es die Schaltkreise:

CSPG: Current Source Pulsgenerator,
PWMT: Pulsweitenmodulator Trigger,
PWMS: Pulsweitenmodulator Switch,
HLR: High-Low Referenz und einen Schaltkreis für
FFPWM: ECL-Flip-Flop ECL-FF2, Pulsweitenmodulation PWM.

Einzelne Schaltkreise sind mit Steueranschlüssen versehen. Über diese Steueranschlüsse ist die Frequenz sowie das Impuls/Pause Verhältnis des Ausgangssignals (Durchschaltesignals) Up beeinflußbar. Das Ausgangssignal Up weist die Spannungspegel MOSL, MOSH auf. Über den Steueranschluß CVCO, IREG, OPTO, I/F kann einerseits auf die Frequenz des Ausgangssignals Up und andererseits über die Steueranschlüsse CPG und PG auf das Impuls/ Pause Verhaltnis des Ausgangssignals Up Einfluß genommen werden. Über den Eingang I/F kann der Gesamtstromverbrauch der Schaltungsanordnung ANSS variiert werden.

Über die an den einzelnen Schaltkreisen VCOS, FCI, VIC sowie PWMS, CSPG angedeuteten Anschlüsse kann auf das Ausgangssignal Up der Schaltungsanordnung ANSS wie nachfolgend zusammengefaßt Einfluß genommen werden:

CVCO: Kondensatoranschluß zur Bestimmung der maximalen Taktfrequenz,
IREG: Stelleingang zur Reduzierung der Frequenz mit eingestellter interner Schwelle durch die mit VA bezeichnete Referenzspannung.
OPTO: Stromstelleingang zur Reduzierung der Frequenz.
I/F: Einstellung der Maximalfrequenz in Verbindung von CVCO.
PG: Vorsteuerung/Reduzierung der "On-Zeit" des Ausgangssignals Up,
CPG: Kondensatoranschluß zur Bestimmung des maximalen Impuls/Pause Verhältnisses.

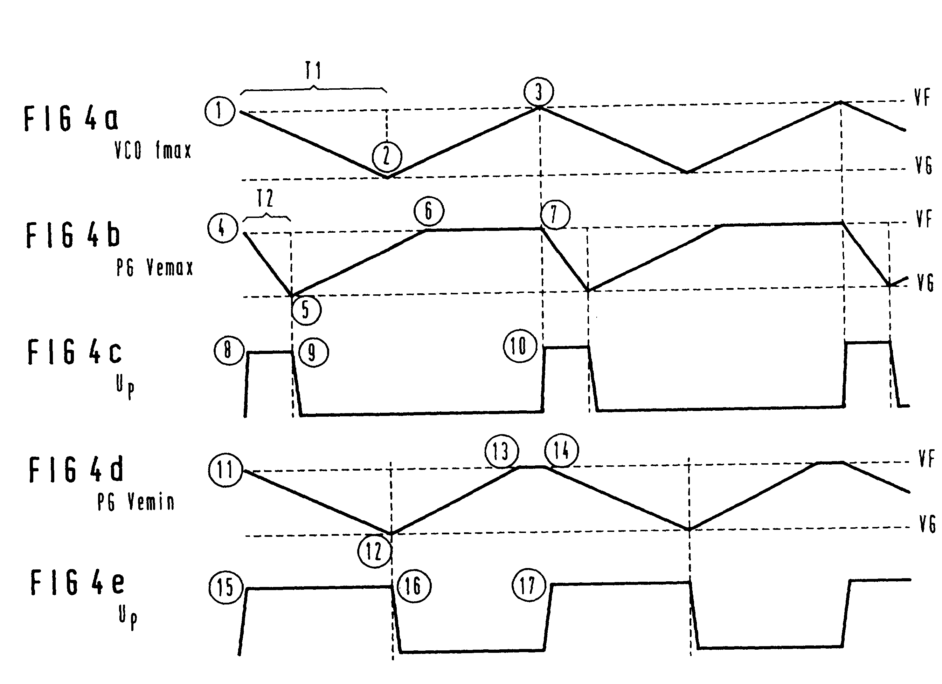

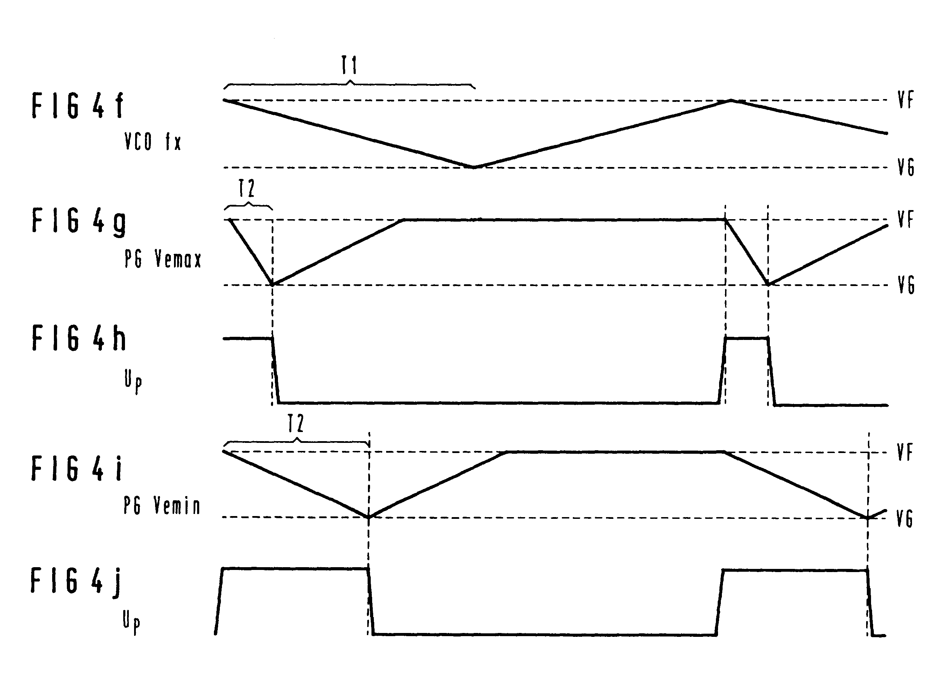

Die in Fig. 3 gezeigte schematische Schaltungsanordnung ANSS ist bei einem geringen Leistungsverbrauch mit hohen Frequenzen steuerbar, wobei über weite Bereiche die Frequenz und das Tastverhältnis (Impuls/Pause Verhältnis) veränderbar sind. Um den Leistungsverbrauch beispielsweise bei schnellen Transistoren mit einer Transitfrequenz von 6 GHz gering zu halten, arbeiten die Transistoren in der Schaltungsanordnung im ungesättigtem Betrieb. Um die Frequenz und das Impuls/Pause Verhältnis des Ausgangssignals Up, gebildet durch die differenziellen Spannungspegel MOSL und MOSH, in einem weiten Bereich zu ändern und temperaturunabhängig zu machen, wird mit über mehrere Dekaden veränderbaren, temperaturkompensierten Strömen gearbeitet. Zur Ausführung von Speicher- und Steuerfunktionen werden Kontrollschaltungsteile CFFVCO, FFPWM benutzt die Komparator und Flip-Flop Eigenschaften besitzen und konstante differenzielle ECL-Ausgangspegel liefern.
Um bei Verringerung der Frequenz eine Anpassung der Eingangsströme des Kontrollschaltungsteiles zu erreichen, wird dessen Eingangsimpedanz ständig angepaßt.
Das Prinzip der in Fig. 3 dargestellten Schaltungsanordnung ist nachfolgend beschrieben. Verweise auf die in Fig. 4 schematisch dargestellten Spannungsverläufe verdeutlichen zusätzlich das Zusammenwirken der einzelnen Schaltkreise. Eine Triggerung des Pulsweitenmodulators PWM erfolgt über den Schaltkreis CFFVCO im VCO, d.h. die Frequenz des Ausgangssignals Up am Ausgang der Schaltungsanordnung ANSS wird vom spannungsgesteuerten Oszillator VCO angegeben. Eine Variation des Impuls/Pause Verhältnisses wird vom Pulsweitenmodulator PWM bewirkt. Liegt beispielsweise keine Stellanforderung über die Anschlüsse OPTO, IREG am Schaltkreis FCI des spannungsgesteuerten Oszillators VCO und keine Stellanforderung am Anschluß PG des Schaltkreises CSPG im Pulsweitenmodulator PWM vor, so weist das Ausgangssignal Up, der Schaltungsanordnung ANSS eine maximale Frequenz VCOfmax auf. Diese maximale Frequenz VCOfmax ist über den Stelleingang I/F des Schaltkreises VIC sowie über den Stelleingang CVCO an der Schaltungsanordnung VCOS einstellbar. Mit einem Widerstand R, der am Anschluß I/F angeordnet ist, ist über den Stromfluß durch den Widerstand R die Frequenz des spannungsgesteuerten Oszillators VCO ebenfalls einstellbar.
Im Pulsweitenmodulator PWM wird durch Änderung der über einen Widerstand am Anschluß PG angelegten Spannung Ue das Impuls/Pause Verhältnis des Ausgangssignals Up beeinflußt. Eingeleitet wird die Variation des Impuls/ Pause Verhältnisses des PWM bei Erreichen einer oberen Referenzspannung VF durch den am Anschluß CVCO angeordneten Kondensator (Fig. 4a, Punkt 1). Mit einem am Anschluß CVCO angeordneten Kondensator C1 wird eine erste Zeitvariable T1 bestimmt. Der spannungsgesteuerte Oszillator VCO leitet über eine Triggerung des Schaltkreises FFPWM eine Entladung des am CPG Anschluß angeschlossenen zweiten Kondensators C2 (Fig.4b, Punkt 4) ein. Mit der Entladung des Kondensators C2 wird eine zweite Zeitvariable T2 bestimmt.
Dieser Entladevorgang, gesteuert durch die Schaltkreise PWMS und PWMT ist durch die Wahl der Stellgröße C2 am Anschluß CPG am Schaltkreis PWMS so bemessen, daß die maximal gewünschte Impulsweite vorgegeben ist. Bei

Erreichen einer unteren Referenspannung VG (Fig.4b, Punkt 5), die einen unteren Umschaltpunkt festlegt, leitet der Pulsweitenmodulator PWM die Impuls-Pause des Ausgangssignals Up der Ansteuerschaltung ANSS ein. Die Entladung des die zweite Zeitvariable T2 beeinflußenden Kondensators am Anschluß CPG ist so bemessen, daß diese schneller abläuft als die Entladezeit des die erste Zeitvariable T1 beeinflussenden Kondensators durch den spannungsgesteuerten Oszillator VCO (Fig.4a, Punkte 1, 2 und Fig.4b, Punkte 4, 5). Die Spannung am Anschluß CPG des PWM verweilt an der oberen Umschalteschwelle VF (FIG.4b, Punkt 6, 7) bis der VCO durch einen Triggerimpuls ausgehend vom Schaltkreis CFFVCO eine erneute Entladung der die erste sowie zweite Zeitvariable T1, T2 bestimmenden Kondensatoren C1, C2 an den Eingängen CVCO und CPG einleitet.

Der Kondensator C2 kann beschleunigt entladen werden und damit die zweite Zeitvariable T2 verkürzt werden, d.h. die "On-Zeit" des Ausgangssignals Up der Ansteuerschaltung ANSS verkürzt sich entsprechend der Höhe des an PG anliegenden Potentials (Fig.4b, Punkt 4, 5; 8, 9; 15, 16). Da das Signal der PWM-Schaltung an der oberen Schwelle der Referenzspannung VF verharrt (Fig.4b, Punkt 6, 7; 13, 14), ist eine unabhängige Stellung der Pulsweite von der Frequenz des spannungsgesteuerten Oszillators VCO realisiert und eine Verkürzung jeweils über den Anschluß PG möglich.

Die Anschlüsse IREG/OPTO ermöglichen eine Frequenzvariation des Ausgangssignales des spannungsgesteuerten Oszillators VCO (Fig. 4f). Eine Stellanforderungen über beide Eingänge führt, beispielsweise zu einer linearen Reduzierung der Frequenz des Ausgangssignales Up, wobei die Pulseinschaltzeit dieser Frequenz erhalten bleibt (Fig. 4g). Da die Entladezeit der zweiten Zeitvariablen (PWM) nur verkürzt werden kann (durch Anschluß PG), ergibt sich bei einer Stellanforderung über die Anschlüsse IREG und OPTO für das Puls-Pause Verhältnis eine weitere Reduzierung.

Die Ablaufsteuerung mit variabler Frequenzeinstellung sowie variabler Einstellung der Pulsdauer ermöglicht eine Anpassung der Leistungsanforderung (Sekundärseite) am Ausgang des Umrichters.

Die Kontrolle des Einschaltimpulses für einen zu steuernden Schalttransistor in Abhängigkeit von der Eingangsspannung Ue des Umrichters erfolgt über den Stelleingang PG. Der Stellvorgang über den Anschluß PG des Schaltkreises CSPG ist so bemessen, daß für die kleinste Eingangsspannung ein Schutz des Schalttransistors gewährleistet ist. Durch beispielsweise eine umgekehrt proportionale Verkürzung des Einschaltimpulses im Verhältnis zur Eingangsspannung ist dieser Schutz in einem weiten Bereich für größere Eingangsspannungen gegeben. Die Eingangsspannung des Umrichters und die Pulsdauer des Schalttransistors verhalten sich umgekehrt Proportional, wobei durch den sich am Anschluß CPG angeordneten Kondensator C2, der die Zeitvariable T2 des PWM bestimmt, ein integraler Verlauf der Eingangsspannung (Ue) des Umrichters berücksichtigt wird (Feed-Forward-Regelung des Schalttransistors). Die in Fig.4c und 4e gezeigten Spannungsverläufe geben das Impuls/Pause Verhältnis des Ausgangssignals Up bei maximaler Frequenz (VCO fmax, Fig.4a) wieder. Die Impulsdauer wird jeweils durch das Erreichen einer "unteren" Referenzspannung VG bestimmt. Die Zeitvariable T2 ist kleiner (<)der minimalen Zeitvariablen T1. Ausgelöst wird die Zeitvariable T2 jeweils bei Erreichen einer "oberen" Referenzspannung VF (FIG 4b, 4d, Punkt 7, 14). Die in den Figuren 4f bis 4j wiedergegebenen Spannungsverläufe geben das Impuls/Pause Verhältnis des Ausgangssignals Up bei einer verringerten Frequenz VCOfx des spannungsgesteuerten Oszillators VCO wieder. Fig 4h, 4j zeigt ein geringeres Impuls/Pause Verhältnis bei gleicher Stellanforderung (vergleiche Fig 4b, 4g; 4d, 4i) am Stelleingang PG (PGVmax, PGVmin). Die Frequenz VCOfmax (Fig. 4a) kann über einen der Stelleingänge IREG oder OPTO am Schaltkreis FCI des VCO reduziert werden (Fig. 4f).

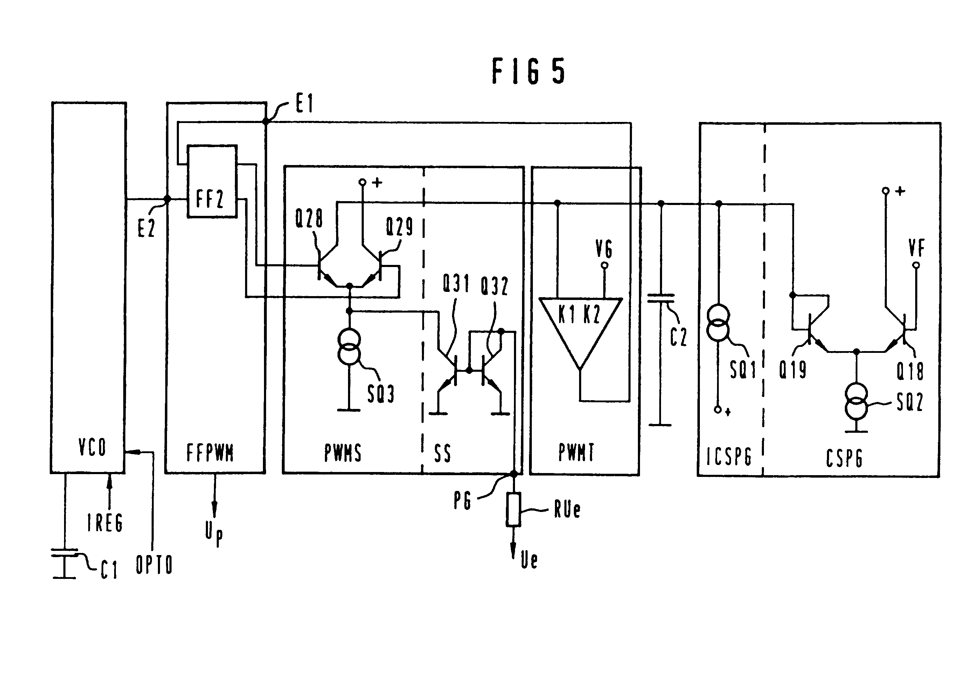

In Fig. 5 ist eine schematische Darstellung der Schaltungsanordnung zur Ansteuerung eines Umrichters abgebildet. Über einen dynamischen Triggereingang am Schaltkreis FFPWM wird ein in diesem angeordnetes ECL Flip-Flop ECL-FF2 gesetzt. Ein am Ausgang der Schaltungsanordnung FFPWM anliegendes Signal, schaltet die Emittter-Kollektor Strecke des in der Differenzstufe Q28, Q29 des Schaltkreises PWMS angeordneten Transistors Q28; Q25 übernimmt den Strom der Stromquelle SQ3. Der Kondensator C2 wird über die Stromquelle SQ3 , die am Emitter der Differenzstufe Q28, Q29 angeordnet ist entladen (siehe Fig.4 Punkt 4, 7, 14). Die Entladung des Kondensators C2 erfolgt linear. Die Entladung kann entsprechend einer Ansteuerung des sich am Emitter der Differenzstufe Q28, Q29 angeordneten Stromspiegels, gebildet aus den Transistoren Q32, Q31, variiert werden. Die Linearität der Entladung des Kondensators C2 bleibt dabei erhalten. Eine, die Entladung des Kondensators C2 beeinflußende Stellgröße Ue liegt dabei an einem Widerstand RUe, der an der Anode des als Diode betriebenen Transistors Q32 des Stromspiegels angeordnet ist. Die Zeit der Entladung des Kondensators ist dabei umgekehrt proportional der an dem Widerstand Rue anliegenden Stellgröße Ue (siehe Fig 4, Zeitvariable T2 zwischen den Punkten 4-5, 11-12). Die Entladung des Kondensators C2 wird beendet, wenn ein dem Spannungspotential entsprechendes Potential VG erreicht ist (PWMT; Q21, Q24). Über die in der Schaltungseinheit PWMT angeordnete Differenzstufe Q21, Q24 erfolgt über den Kollektor des Transistors Q24 ein Resetsignal, das an die Schaltungseinheit FFPWM weitergeleitet wird. Das in der Schaltungsanordnung FFPWM angeordnetes Flip-Flop ECL-FF2 bewirkt ein Potentialwechsel des Ausgangssignals. Ein Pegelwechsel des ECL-Ausgangssignals bewirkt bei der in der Schaltungseinheit PWMS angeordneten Differenzstufe Q28, Q29 ein Sperren des Transistors Q28. Eine weitere Entladung des Kondensators C2 wird dadurch verhindert. Der Kondensator C2 wird jetzt auf eine "obere" Referenzspannung VF aufgeladen. Während der Aufladephase des Kondensators C2 ist nur die an Basis/Kollektor des als Diode geschalteten Transistors Q19 angeschlossene Stromquelle SQ1 aktiv. Erreicht das Potential am Kondensator C2, das Potential der Referenzspannung VF, so wird wegen der größer dimensionierten Stromquelle SQ2 am Emitter von Q19 der Aufladevorgang beendet. Über den Emitter des als Diode betriebenen Transistors Q19 wird der Strom, der die Aufladung des Kondensators C2 bewirkt hat, nach Masse abgeleitet. Der Kondensator C2 befindet sich nunmehr in Wartestellung, bis ein erneuter Triggerimpuls, der beispielsweise von dem spannungsgesteuerten Oszillator VCO an den Funktionsblock PWM über E2 weitergereicht wird, eine erneute Entladung des Kondensators C2 einleitet.

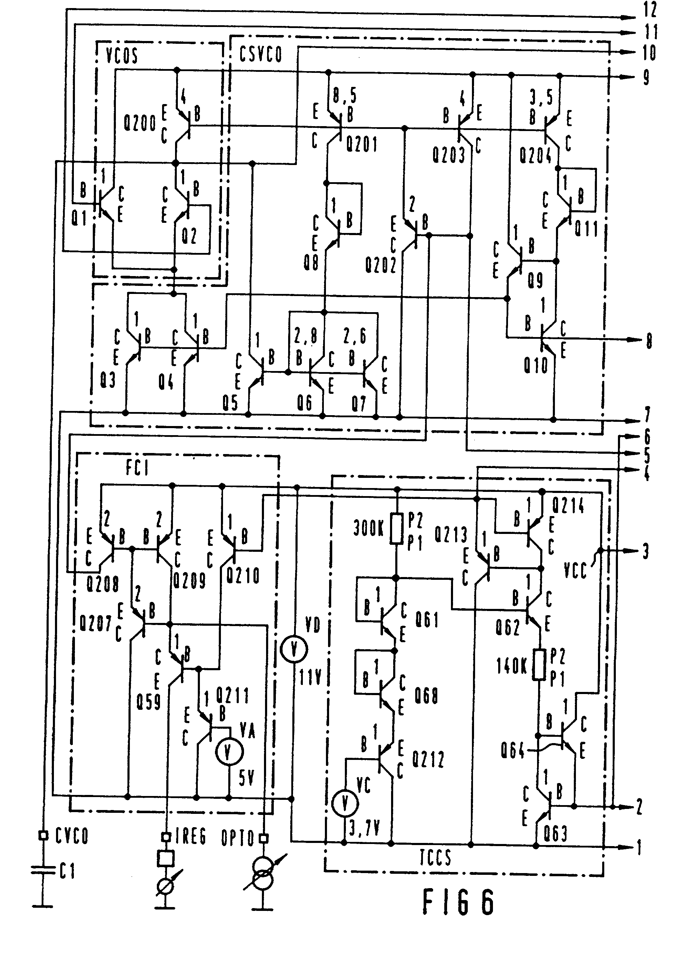

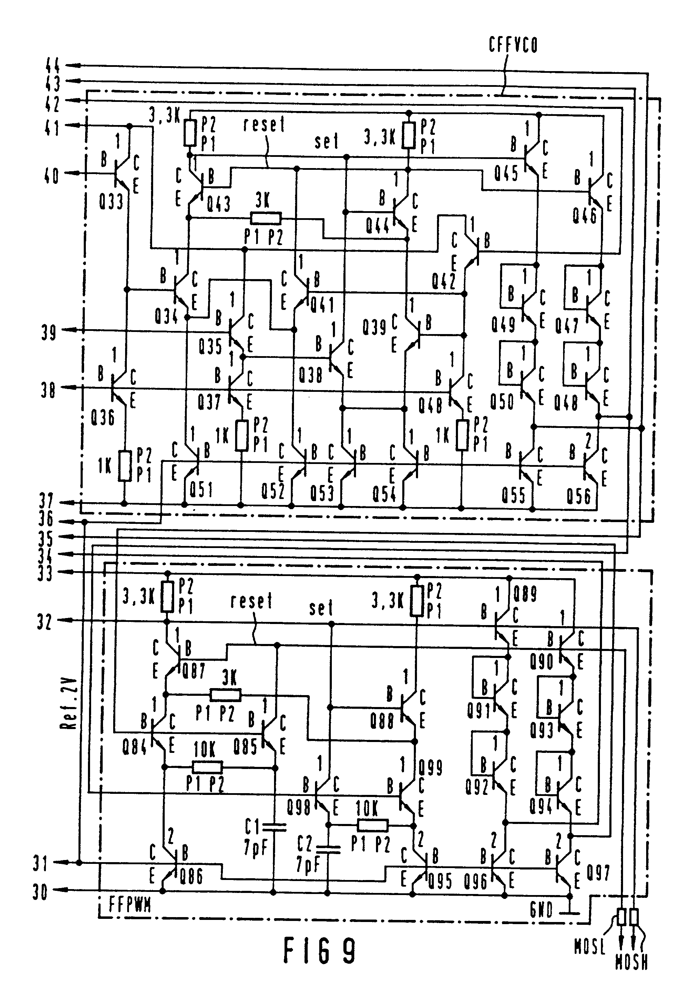

In Fig. 6, 7, 8, 9 ist eine detaillierte Schaltungsanordnung der in Fig. 3 gezeigten schematischen Darstellung wiedergegeben. Die Funktionsweise der Schaltungsanordnung ist nachfolgend beschrieben:

Am Anschluß I/F der Schaltkomponente VIC wird über die Transistoren Q70, Q71 eine Spannungs-Stromwandlung vorgenommen. Durch eine Bufferschaltung gebildet durch die Transistoren Q65 ... Q71, Q215 ... Q217 und die Spannungsquelle VD, die als Band-Gap ausgebildet ist, wird erreicht, daß der durch die Transistoren Q70, Q71 extrahierte Strom, temperaturunabhängig ist und sich dadurch die Frequenz über den Temperaturbereich nicht ändert.

Der Strom, der im Kollektor von Q71 des Schaltkreises VIC fließt, wird dem Schaltkreis CSPG zugeführt. Der Strom, der im Kollektor von Q70 fließt wird dem Stromspiegel CSVCO Q200 ... Q204 zugeführt. Q200 ... Q204 bilden mit Q3 ... Q11 den Stromgenerator für den frequenzvariablen Betrieb.

Über den VCOS, der durch die Transistoren Q1, Q2 gebildet ist, erfolgt die Umladung von CSVCO. An den Basen der Transistoren Q1, Q2 liegt eine differenzielle Spannung an. Je nach Aussteuerung der Basen wird CSVCO über Q200 aufgeladen oder über Q3, Q4 entladen, da der Entladestrom, der in Q 204 generiert wird, im Verhältnis 2 : 1 gespiegelt wird (Transistoren Q9, Q10, Q3, Q4). Die Transistoren Q8, Q7, Q6, Q5, Q201 dienen einer gewünschten Anpassung des Puls-Pause-Verhältnis von 56,37%. Der Verlauf der Spannung des CSVCO ist dreieckförmig und das Impuls-Pause-Verhältnis vollkommen unabhängig von der Größe des Stromes CSVCO, da die Stromquellen im festen Verhältnis zueinander stehen. Die Größe der Dreiecksamplitude, die sich im CSVCO ergibt, wird durch die Referenzspannungen VF und VG festgelegt, welche über die Transistoren Q124, Q122, Q80 bzw. Q125, Q123, Q81 dem PWMT und dem CFFVCO (Komparator/ECL-Flip-Flop-Frequenz) zugeführt werden. Über Q33 und Q35 liegen die Referenzspannungen an dem Komparator CO, ECL-Flip-Flop/Frequenz, welcher über Q42 die Spannung am VCO mit diesen Referenzspannungen vergleicht. Erreicht VCOS den oberen oder unteren Wert der Referenzspannung, erfolgt über Q41 bei Erreichen von VF-Reset oder bei Erreichen von VG über Q38-Set an dem Flip-Flop Q43, Q44. An den Flip-Flop Transistoren Q43, Q44 ergibt sich durch die Wahl des Stromes in den Stromquellen Q51, Q52, Q53, Q54 und den Kollektorwiderständen von 3,3 K ein differentielles Signal von 320mV, welches über Q45 ... Q50 den Schalter Q1, Q2 umschaltet.

Die Besonderheit der bisher beschriebenen Schaltkreise ergibt sich aus dem Aufbau der Eingangsschaltung, die über Q36, Q37, Q40 den Strom aus Spannungsquelle Q9, Q10 in die Eingangsstufen des Komparators spiegelt. Hier ergibt sich erfindungsgemäß der Vorteil, daß der Eingangsstrom an der Basis von Q42 vom Strom im VCO-Umschalter Q1, Q2 abhängig gemacht wird und somit bei einer Frequenzvariation am Anschluß VCO im Verhältnis 1:100 sich dieser Basisstrom um das gleiche Verhältnis verändert, wodurch die Darlingtonstufe Q42, Q39, Q41 in der Geschwindigkeit der VCO-Frequenz angepaßt wird und der sich ergebende Frequenz fehler durch den Basisstrom in Q42 gering gehalten wird.

Da die Stromquellen Q51 ... Q56 mit dem fest eingestellten Strom arbeiten, ist durch die Darlington-Eingangstransistoren Q33/Q34, Q35/Q38, Q42/Q41, Q42/Q39 die Impedanzanpassung an den VCO-Strom und die Umsetzung in konstante ECL-Pegel in den Kollektoren Q43, Q44 möglich.

Die Frequenzeinstellung erfolgt dabei durch folgende Schaltungsausprägung: Bei den im Schaltungsbeispiel ausgeführten Spiegelverhaltnis der Transistoren, ist die Maximalfrequenz des VCO durch den eingestellten Strom am Anschluß I/F, der Größe der Amplitude, VF - VG und die Größe des Kondensators am Anschluß VCO bestimmbar. Die Zeiten t1, t2, die Frequenz des VCO und das Puls-Pause-Verhältnis können wie folgt bestimmt werden:

$$t1 = \frac{C_{VCO} \cdot 0.6}{\frac{1.26}{R_{IF} \cdot 2}}\, [s] \qquad (6) \qquad t2 = \frac{C_{VCO} \cdot 0.6}{\frac{1.26}{R_{IF} \cdot 2} \cdot 0.774}\, [s] \qquad (7)$$

die Frequenz des VCO:

$$f_{VCO} = \frac{1}{t1 + t2} = \frac{0.458}{C_{VCO} \cdot R_{IF}}\, [Hz] \qquad (8)$$

das Impuls-Pause-Verhältnis:

$$D_R = \frac{t2}{t1 + t2} = 56.37\% \tag{9}$$

VF - VG = 0,6V Dreiecksspannungshub
VD = 1,26V (Band-Gap Spannung)

$R_{I/F}$:    Widerstand am Anschluß I/F
$f_{VCO}$:    Frequenz des spannungsgesteuerten Oszillators
$D_R$ :    Impuls- Pause Verhältnis

Eine Einstellung der Frequenz ist über die Anschlüsse IREG und OPTO am Schaltkreis FCI durchführbar, wobei die Frequenz des VCO verringert wird.

Der Stromspiegel Q208, Q209 spiegelt im Kollektor von Q208 den aus den Anschlüssen IREG oder OPTO fließenden Strom so in den Stromspiegel Q200 ... Q204, daß sich der Strom von Kollektor Q208 und Q70 subtraktiv überlagern. Erreicht der Wert des Stromes von Kollektor Q208 im Betrag den Wert des Stromes von Kollektor Q70, wird der Stromspiegel Q200 ... Q204 stromlos und die Frequenz am Anschluß VCO ist Null. Folgender Zusammenhang ist dabei gegeben:

$$t1_{opto/ireg} = \frac{C_{VCO} \cdot 0.6}{\frac{1.26}{R_{IF} \cdot 2} - I_{opto} - I_{opto}} \; [s] \tag{10}$$

$$t2_{opto/ireg} = \frac{C_{VCO} \cdot 0.6}{\left(\frac{1.26}{R_{IF} \cdot 2} - I_{opto} - I_{opto}\right) \cdot 0.774} \; [s] \tag{11}$$

$$f_{VCOopto/ireg} = \frac{1}{t1_{opto/ireg} + t2_{opto/ireg}} \; [Hz] \tag{12}$$

$t1_{opto/ireg}$:    Entladezeit des Kondensators CVCO am Anschluß VCO bei Stellung an den Anschlüssen OPTO oder IREG

$t2_{opto/ireg}$:    Aufladezeit des Kondensators CVCO am Anschluß VCO bei Stellung an den Anschlüssen OPTO oder IREG

fVCO opto/ireg:   Frequenz des VCO bei aktiven Anschlüssen OPTO ODER IREG

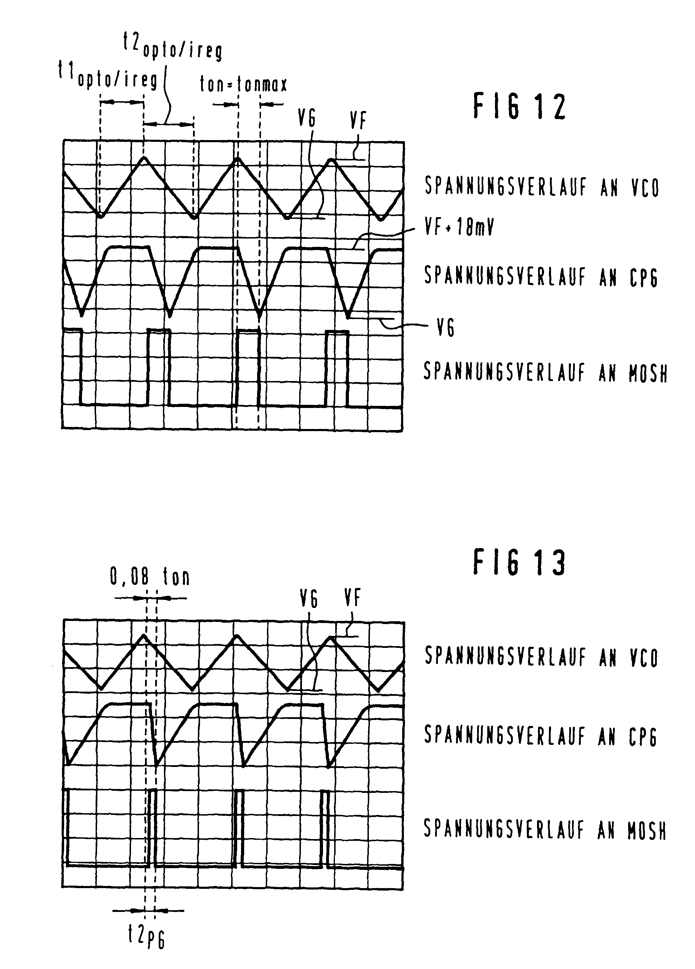

Durch diese Art der Frequenzeinstellung ist ein großer Bereich der Frequenzvariation gegeben. In Figur 4 sowie Figur 10 bis 13 ist diesbezüglich der Zusammenhang grafisch dargestellt. An einem integrierten Ausführungsbeispiel ist eine Frequenzvariation von mehr als 1 : 700 realisierbar.

Die Eingänge OPTO und IREG werden am Kollektor Q209 (FCI) zusammengeführt und wirken auf die Frequenzstellung als ODER-Schaltung. Somit kann beispielsweise OPTO eine Kontrollfunktion der Sekundärseite des Wandlers über einen Optokoppler vornehmen und IREG eine Kontrolle des Maximalstromes des primärseitigen Leistungstransistors ermöglichen.

Eine Pulsweitenmodulation erfolgt bei der in Fig. 6, 7, 8, 9 dargestellten Schaltungsanordnung wie nachfolgend erläutert: Über den PWMS Q28, Q29 wird der am Anschluß CPG angeordnete Kondensator gesteuert. Bei gleicher Größe der Kondensatoren CVCO und CPG wird, falls keine Einstellung an den Anschlüssen OPTO und IREG erfolgt durch die Einstellung der Stromquelle Q206, Q15/Q16, Q30, Q75 gegenüber den Stromquellen Q200, Q3/Q4, sich der Kondensator am Anschluß VCO geringfügig (ohne Korrektur von Q17, Q18, Q19) schneller entladen und die untere Schwelle, die mit VG vorgegeben ist, erreichen. Dadurch wird über Q35, Q38 ... Q43, Q44 am ECL-Flip-Flop Q43, Q45 ein Set ausgeführt. Über die Level-shift-Anordnung Q45 ... Q50 gelangt das differenzielle Signal an Q84, Q98 und führt hier über Q98 ein Set im ECL-Flip-Flop Q87, Q88 aus. Durch die Schaltungsausgestaltung der Ansteuerschaltung des ECL-Flip-Flop/PWM (PWM) wird eine stromsparende Triggerung mit einem geringen Komponentenaufwand und geringen Laufzeiten erreicht. Nur positive Flanken an den Emittern von Q50, Q48 sind in der Lage ein Set oder Reset auszuüben. Ein Set erfolgt mit Q98, der den Set-Strom aus C2 entnimmt. Ein Reset erfolgt mit Q85, der den Reset-Strom aus C1 entnimmt. Die Zeitkonstanten C1, C2, R (10K Ohm), sind so bemessen, daß bezüglich der höchsten VCO-Frequenz VCOfmax ein Set oder Reset sicher in der halben Periodendauer abgeklungen ist.

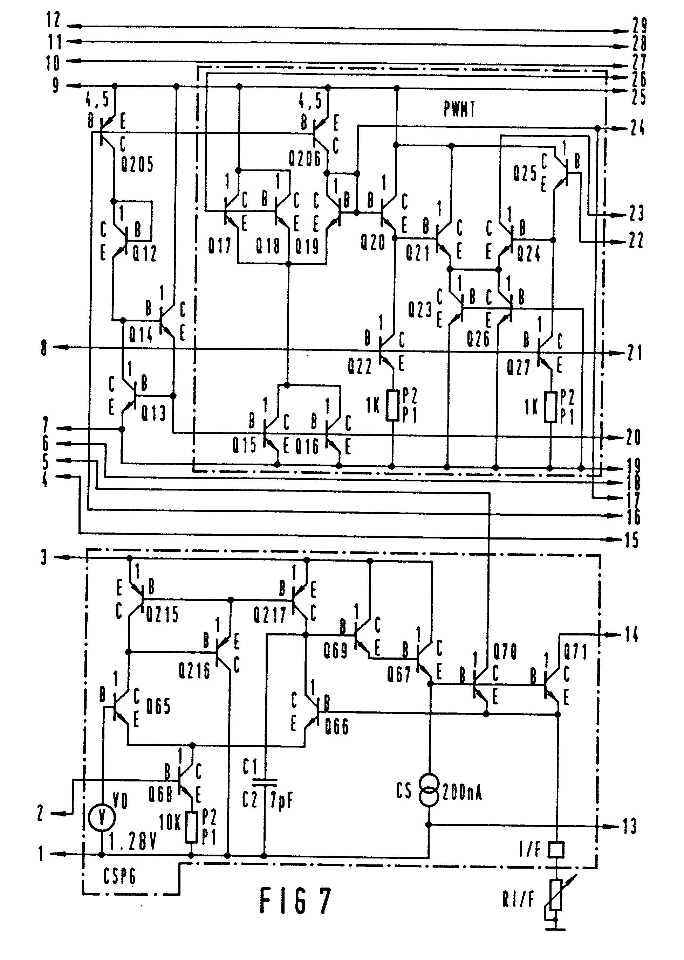

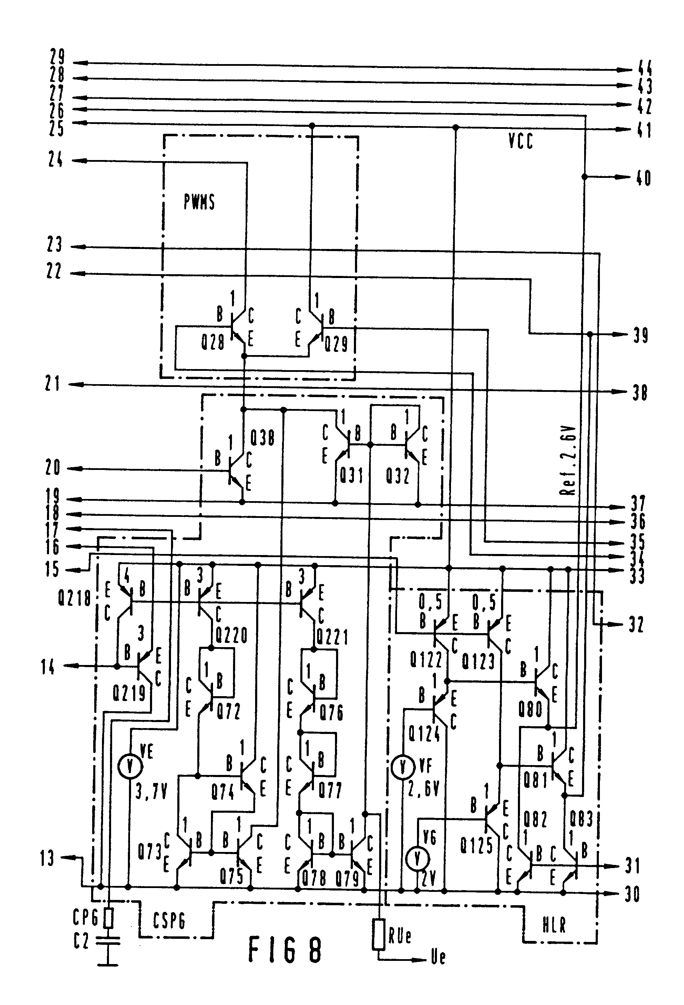

Über die Level-Shift-Anordnung Q89 ... Q94 wird nach erfolgtem Set der Schalter Q28, Q29 im PWMS umgeschaltet. Der Kondensator C2 am Anschluß CPG lädt sich über Q206 auf. Der Strom im Kollektor Q206 ist wiederum so eingestellt, daß die Aufladung früher als am Kondensator C2 am Anschluß CVCO abgeschlossen ist. Erreicht das Potential am Kondensator C2 die Spannungspegel VF, verharrt er an diesem Spannungspegel, Fig. 7 und Fig. 8, wegen der Differenzstufe Q17/Q18, Q19, dem Gleichgewicht der Ströme Q206/Kollektor Q19/Kollektor/Basis und der Ausführung von Q19 als Diode. Die unsymmetrische Ausbildung der Differenzstufe Q17 ... Q19 mit der Fläche 2 : 1 ergibt eine gewünschte Korrektur des Spannungspegels um +18 mV auf den sich der Kondensator C2 gegenüber VF auf lädt, weil bei Entladung nicht sofort der volle Strom im Kollektor von Q15, Q16 von Q17, Q18 übernommen wird (siehe Fig. 6).

Ausgehend von diesen Voreinstellungen erfolgt die Stellung der Pulsbreite durch RUe am Anschluß PG. Über den Kollektor Q79 wird zunächst ein Strom I vom Stromspiegel Q32, Q31 nach GND abgeleitet. RUe ist so bemessen, daß bei der unteren Eingangsspannung Ue ein Stromgleichgewicht zwischen dem Entladestrom von Kollektor Q79 und dem Strom in RUe vorhanden ist. Vergrößert sich die Spannung an RUe so wird der Stromspiegel Q32, Q31 aktiv und trägt in der Entladephase des Kondensators CPG zu dessen schnelleren Entladung bei. Über die Differenzstufe Q20 ... Q27, die durch die Basis von Q25 und dem Buffer Q125, Q81 mit der unteren Referenzspannung VG verbunden ist, wird bei Entladung des Kondensators CPG auf VG über den Kollektor von Q24 am Flip-Flop Q87, Q88 ein Set ausgeführt, wodurch über den Level-shift Q89 ... Q84 die Differenzstufe Q28, Q29 umgeschaltet wird und der Aufladevorgang am Kondensator C2 beginnt.

Betrachtet man diesen Vorgang unter der Annahme, daß die Entladung des Kondensators C2 schneller stattgefunden hat als die Entladung des Kondensators CVCO, so ist festzustellen, daß am ECL-Flip-Flop/PWM ein Set ausgeübt wurde, ohne daß eine Beeinflußung vom Komparator, ECL-Flip-Flop/Frequenz VCO vorhanden war.

Ein Set, durch das Flip-Flop Q43, Q44 bleibt wirkungslos, weil Q87, Q88 bereits gesetzt ist. Da jedoch der Kondensator C2 bei Erreichen der Spannung VF verharrt und nur ein Reset an Q87, Q88 durch Q43, Q44 ausgeführt werden kann, ist nun folgender Zusammenhang für die ECL-Signale an MOSL/MOSH hergestellt: Die Frequenz ist durch die Zeitvariable T1, $R_{I/F}$ und den Hub VF-VG festgelegt. Die Pulsbreite kann über die Spannung Ue kontinuierlich verringert werden. Die Pulsbreite verhält sich durch die Ausführung der Schaltung umgekehrt proportional zur Eingangsspannung Ue; eine Verdopplung der Eingangsspannung führt zur Halbierung der Pulsbreite.
Folgender Zusammenhang ist mit den vorhandenen Spiegelverhältnissen der Transistoren des Ausführungsbeispiels gegeben:

$$t2_{PG} = \frac{C_{VCO} \cdot 0.6}{\frac{1.26}{R_{IF} \cdot 2} \cdot 0.75 + \left(\frac{Ue}{R_{Ue}} - \frac{1.26}{R_{IF} \cdot 2} \cdot 0.75\right)} \, [s] \qquad (13)$$

für

$$\frac{Ue}{R_{Ue}} > \frac{1.26}{R_{IF} \cdot 2} \cdot 0.75 \qquad (14)$$

Einsatzschwelle für On-Zeit-Verkürzung

$$\frac{Ue}{R_{Ue}} = \frac{1.26}{R_{IF} \cdot 2} \cdot 0.75 \qquad (15)$$

$t2_{PG}$:      ON-Zeit bei Pulsweitenstellung
$U_e/R_{Ue}$:      Strom für On-Zeit-Verkürzung

Die Diodenflußspannung Q23 ist hier nicht berücksichtigt, kann aber für genauere Betrachtungen von Ue subtrahiert werden.

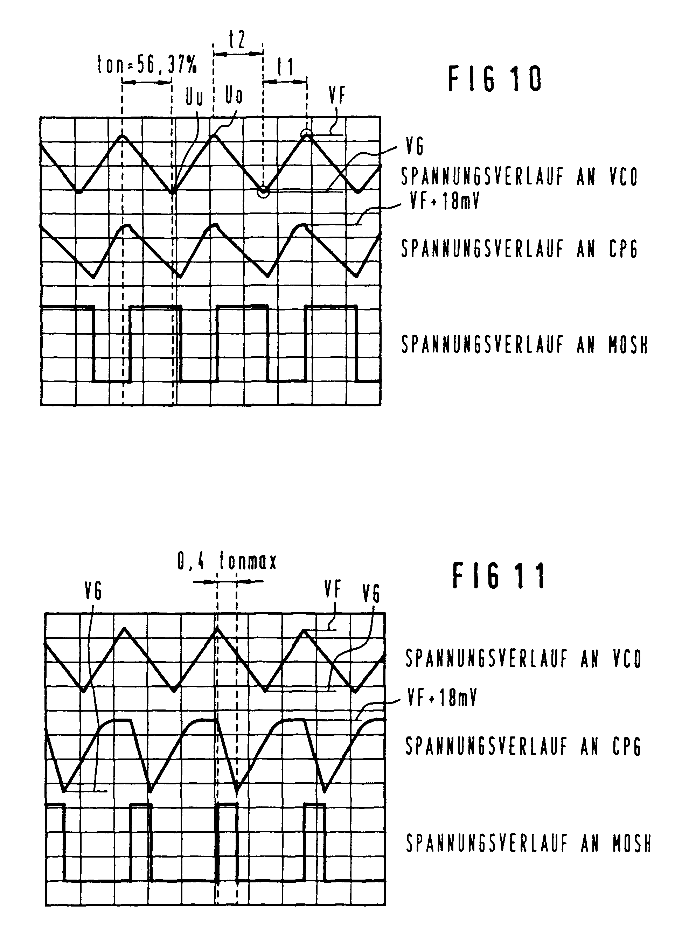

Die Figuren 10, 11 und 12 zeigen Spannungsverläufe am Anschluß MOSH in Abhängigkeit von $U_e$.

Da die Eingangsspannung Ue über den Strom in Rue direkt auf den Kondensator CPG wirkt, kann die Pulsbreite ohne Verzögerung variiert werden. Durch den Anschluß von RUe an die Eingangsspannung und Wirkung auf die Pulsbreite bei Überschreitung der Schwellenspannung Ue ist eine weitere Bedingungen abgesichert, die darin besteht, daß falls über IREG oder OPTO die Frequenz am CSVCO verringert wird, sich die Periodendauer erhöht, die Pulsdauer sich aber nicht verändern kann, da durch die Voreinstellung der Spannungsverläufe an VCO und CPG in der Art, daß der Spannungsverlauf für die Maximalfrequenz bei Entladung an CPG um weniger als 1% langsamer verläuft als an CVCO, der. Set Impuls für das Flip-Flop Q87, Q88 bei Frequenzverringerung sofort durch Q24 erfolgt. Die Schaltung ermöglicht somit eine unabhängige Stellung von Pulsbreite und Frequenz. Nur bei der eingestellten Maximalfrequenz und minimaler Eingangsspannung Ue wird das größte Puls-Pause erreicht.

Fig. 10 zeigt den Spannungsverlauf am Anschluß MOSH ohne Pulsverkürzung über den Anschluß PG.

Fig. 11 zeigt den Spannungsverlauf am Anschluß MOSH mit Pulsverkürzung von 0.4 $T_{max}$ MOSH über den Anschluß PG:

Fig. 12 zeigt den Spannungsverlauf an MOSH mit Pulsverkürzung von 0.08$T_{max\ MOSH}$über den Anschluß PG.

Fig. 13 zeigt einen Spannungsverlauf an MOSH durch Frequenzstellung mit Stromeinprägung an den Anschlüssen OPTO oder IREG. PG ist nicht aktiv.

**Patentansprüche**

1. Schaltungsanordnung (ANSS) zur Ansteuerung eines Schalt-Umrichters (5) oder Schaltnetzteils mit einem an einen Pulsweitenmodulator (PWM) angeschossenen spannungsgesteuerten Oszillator (VCO) und einen im Hauptstromkreis des Umrichters (5) angeordneten elektronischen Schalter (4), wobei der elektronische Schalter (4) von einem Durchschaltesignal (Up) gesteuert wird, dessen Frequenz (VCOfx) über mindestens einen Steuereingang (IREG, OPTO) des Oszillators (VCO) und dessen Impuls/Pause Verhältnis (DR) über mindestens einen Steuereingang (PG) des Pulsweitenmodulators (PWM) veränderbar ist, wobei der Pulsweitenmodulator (PWM) eine kapazitive Speichereinheit (C2) aufweist, die mit einer Entladeeinheit (PWMS) und einer Ladeeinheit (ICSPG) sowie mit einem ersten Eingang (K1) eines Komparators (PWMT) verbunden ist, dessen zweiter Eingang (K2) mit einer ersten Referenzspannung (VG) verbunden ist,
   **dadurch gekennzeichnet,**

   daß die Ladeeinheit (ICSPG) mit einer weiteren Vergleichseinheit (CSPG) verbunden ist,
   daß eine Steuereinheit (FFPWM) vorgesehen ist, deren erster Eingang (El) mit dem Ausgang des Komparators (PWMT) und deren zweiter Eingang (E2) mit dem Ausgang des Oszillators (VCO) verbunden ist,
   daß mindestens ein Ausgang der Steuereinheit (FFPWM) mit der Entladeeinheit (PWMS) verbunden ist,
   daß, von dem Oszillator (VCO) gesteuert, durch die Steuereinheit (FFPWM) eine von einem definierten Potential ausgehende Entladung des Speicherelementes (2) eingeleitet wird während von der Steuereinheit (FFPWM) das Durchschaltesignal (Up) abgegeben wird,
   daß bei Erreichen der am Komparator (PWMT) anliegenden ersten Referenzspannung (VG) durch ein zur Steuereinheit (FFPWM) geführtes Ausgangssignal des Komparators (PWMT) die Entladung und mit ihr das Durchschaltesignal (Up) beendet wird und
   daß anschließend das Speicherelement (C2) erneut auf das definierte Potential aufgeladen wird.

2. Schaltungsanordnung nach Anspruch 1,
   **dadurch gekennzeichnet,**

   daß als Ladeeinheit (ICSPG) eine mit einem Anschluß an dem Betriebspotential angeschaltete erste Konstantstromquelle (SQ1) vorgesehen ist,
   daß die Vergleichseinheit (CSPG) aus einer zweiten Konstantstromquelle (SQ2) und aus einem an deren Ausgang angeschalteten Emitter eines mit dem Kollektor an das Betriebspotential angeschalteten ersten Transistors (Q18), dessen Basis an einer zweiten Referenzspannung (VF) liegt, und einer ebenfalls an den Ausgang der zweiten Konstantstromquelle (SQ2) angeschalteten ersten Diode (Q19), die in Reihe mit der ersten Konstantstromquelle (SQ1) geschaltet ist, besteht.

3. Schaltungsanordnung nach Anspruch 1,
   **dadurch gekennzeichnet,**

daß die Entladeeinheit (PWMS) aus einer Differenzstufe (PWMS) mit zwei emittergekoppelten Transistoren (Q28, Q29) und einer dritten Konstantstromquelle (SQ3) gebildet ist, zu der ein Transistor (Q31) einer Stromspiegelschaltung (SS) parallel geschaltet ist und an der Basis des Transistors (Q31) der Stromspiegelschaltung (SS) sowohl die Anode einer zweiten Diode (Q32) als auch ein Widerstand (RUe) angeordnet ist, daß an dem Widerstand (RUe) eine den Transistor (Q31) der Stromspiegelschaltung (SS) steuernde Stellgröße (Ue) anliegt.

4. Schaltungsanordnung nach einem der vorhergehenden Ansprüche,
   **dadurch gekennzeichnet,**

   daß die Stellgröße (Ue) die Eingangsspannung ist.

5. Schaltungsanordnung nach einem der vorhergehenden Ansprüche,
   **dadurch gekennzeichnet,**

   daß die Entladung des Speicherelementes (C2) und eines weiteren die Folgefrequenz (VCOfx) des Oszillators (VCO) beeinflußenden weiteren Speichereinheit (C1) durch zwei sich seriell triggernde Kippstufen (FF1, FF2) eingeleitet wird, wobei die erste Kippstufe (FF2) in der Steuereinheit (FFPWM) des Pulsweitenmodulators (PWM) und eine weitere Kippstufe (FF1) im Oszillator (VCO) angeordnet ist.

6. Schaltungsanordnung nach einem der vorhergehenden Ansprüche,
   **dadurch gekennzeichnet,**

   daß das Impuls/Pause Verhältnis (DR) des Durchschaltesignals (Up) unabhängig von der maximalen Folgefrequenz (VCOfmax) des Oszillators (VCO) einstellbar ist.

7. Schaltungsanordnung nach einem der vorhergehenden Ansprüche,
   **dadurch gekennzeichnet,**

   daß die Speichereinheiten (C1, C2) Kondensatoren sind.

8. Schaltungsanordnung nach einem der vorhergehenden Ansprüche,
   **dadurch gekennzeichnet,**

   daß bei Verringerung der Folgefrequenz (VCOfx) des spannungsgesteuerten Oszillators (VCO) die Eingangsimpedanz der Nachfolgeschaltungen angepaßt ist.

9. Schaltungsanordnung nach einem der vorhergehenden Ansprüche,
   **dadurch gekennzeichnet,**

   daß die Transistoren im ungesättigtem Betrieb arbeiten.

10. Schaltungsanordnung nach einem der vorhergehenden Ansprüche,
    **dadurch gekennzeichnet,**

    daß mit temperaturkompensierten Strömen gearbeitet wird.

11. Schaltungsanordnung nach einem der vorhergehenden Ansprüche,
    **dadurch gekennzeichnet,**

    daß diese in ECL- und Stromquellenschaltungstechnik auf einen Baustein integrierbar ist.

## Claims

1. Circuit arrangement (ANSS) for driving a switch-mode converter (5) or switch-mode power supply having a voltage-controlled oscillator (VCO) which is connected to a pulse-width modulator (PWM) and having an electronic switch (4) which is arranged in the main circuit of the converter (5), the electronic switch (4) being controlled by a switch-on signal (Up) whose frequency (VCOfx) can be varied via at least one control input (IREG, OPTO) of the oscillator (VCO), and whose duty ratio (DR) can be varied via at least one control input (PG) of the pulse-width modulator (PWM), the pulse-width modulator (PWM) having a capacitive storage unit (C2) which is connected to a discharge unit (PWMS), to a charging unit (ICSPG) and to a first input (K1) of a comparator (PWMT) whose second input (K2) is connected to a first reference voltage (VG),

**characterized**

in that the charging unit (ICSPG) is connected to a further comparison unit (CSPG),

in that a control unit (FFPWM) is provided whose first input (EI) is connected to the output of the comparator (PWMT), and whose second input (E2) is connected to the output of the oscillator (VCO),

in that at least one output of the control unit (FFPWM) is connected to the discharge unit (PWMS),

in that, controlled by the oscillator (VCO), discharging of the storage element (2), originating from a defined potential, is initiated by the control unit (FFPWM) while the switch-on signal (Up) is emitted from the control unit (FFPWM),

in that, on reaching the first reference voltage (VG) which is applied to the comparator (PWMT), the discharging and, with it, the switch-on signal (Up) are ended by an output signal of the comparator (PWMT) which is passed to the control unit (FFPWM), and

in that, subsequently, the storage element (C2) is once again charged to the defined potential.

2. Circuit arrangement according to Claim 1,
**characterized**

in that a first constant current source (SQ1), one of whose connections is connected to the operating potential, is provided as the charging unit (ICSPG),

in that the comparison unit (CSPG) comprises a second constant current source (SQ2) and an emitter, which is connected to its output, of a first transistor (Q18) whose emitter is connected to the operating potential and whose base is at a second reference voltage (VF), and furthermore comprises a first diode (Q19) which is likewise connected to the output of the second constant current source (SQ2) and is connected in series with the first constant current source (SQ1).

3. Circuit arrangement according to Claim 1,
**characterized**

in that the discharge unit (PWMS) is formed from a difference stage (PWMS) having two emitter-coupled transistors (Q28, Q29) and a third constant current source (SQ3), in parallel with which a transistor (Q31) of a symmetrical circuit (SS) is connected, and both the anode of a second diode (Q32) as well as a resistor (RUe) are arranged at the base of the transistor (Q31) of the symmetrical circuit (SS), in that a control variable (Ue), which controls the transistor (Q31) of the symmetrical circuit (SS), is applied to the resistor (RUe).

4. Circuit arrangement according to one of the preceding claims,
**characterized**

in that the control variable (Ue) is the input voltage.

5. Circuit arrangement according to one of the preceding claims,
**characterized**

in that the discharging of the storage element (C2) and of a further storage unit (C1) which influences the repetition frequency (VCOfx) of the oscillator (VCO) is initiated by two multivibrator stages (FF1, FF2) which are triggered in series, the first multivibrator stage (FF2) being arranged in the control unit (FFPWM) of the pulse-width modulator (PWM), and a further multivibrator stage (FF1) being arranged in the oscillator (VCO).

6. Circuit arrangement according to one of the preceding claims,
**characterized**

in that the duty ratio (DR) of the switch-on signal (Up) can be set independently of the maximum repetition frequency (VCOfmax) of the oscillator (VCO).

7. Circuit arrangement according to one of the preceding claims, **characterized**

   in that the storage units (C1, C2) are capacitors.

8. Circuit arrangement according to one of the preceding claims, **characterized**

   in that the input impedance of the downstream circuits is adapted when the repetition frequency (VCOfx) of the voltage-controlled oscillator (VCO) is reduced.

9. The circuit arrangement according to one of the preceding claims, **characterized**

   in that the transistors operate in the unsaturated mode.

10. Circuit arrangement according to one of the preceding claims, **characterized**

    in that temperature-compensating currents are used.

11. Circuit arrangement according to one of the preceding claims, **characterized**

    in that this circuit arrangement can be integrated on a chip using ECL and current source circuit technology.

**Revendications**

1. Circuit (ANSS) pour contrôler un convertisseur de commutation (5) ou un bloc secteur de commutation avec un oscillateur (VCO) contrôlé par la tension et raccordé à un modulateur d'impulsions en largeur (PWM) et avec un commutateur électronique (4) placé dans le circuit principal du convertisseur (5), le commutateur électronique (4) étant contrôlé par un signal de commutation (Up) dont la fréquence (VCOfx) peut être modifiée par l'intermédiaire d'au moins une entrée de commande (IREG, OPTO) de l'oscillateur (VCO) et dont le rapport impulsion/pause (DR) peut être modifié par l'intermédiaire d'au moins une entrée de commande (PG) du modulateur d'impulsions en largeur (PWM), le modulateur d'impulsions en largeur (PWM) comportant une unité de stockage capacitive (C2), laquelle est reliée à une unité de décharge (PWMS) et à une unité de charge (ICSPG), ainsi qu'à une première entrée (K1) d'un comparateur (PWMT), la deuxième entrée (K2) de ce dernier étant reliée à une première tension de référence (VG),
**caractérisé par le fait**

   que l'unité de charge (ICSPG) est reliée à une autre unité de comparaison (CSPG),
   qu'une unité de commande (FFPWM) est prévue, dont la première entrée (E1) est reliée à la sortie du comparateur (PWMT) et dont la deuxième entrée (E2) est reliée à la sortie de l'oscillateur (VCO),
   qu'au moins une sortie de l'unité de commande (FFPWM) est reliée à l'unité de décharge (PWMS),
   que, sous le contrôle de l'oscillateur (VCO), l'unité de commande (FFPWM) initie, en se référant à un potentiel défini, une décharge de l'élément de stockage (2) alors que l'unité de commande (FFPWM) émet le signal de commutation (Up), que, lorsque la première tension de référence (VG) appliquée au comparateur (PWMT) est atteinte, un signal de sortie du comparateur (PWMT) envoyé à l'unité de commande (FFPWM) interrompt la décharge et, avec elle, le signal de commutation (Up) et
   que l'élément de stockage (C2) est ensuite rechargé au potentiel défini.

2. Circuit selon la revendication 1
**caractérisé par le fait**

   qu'une première source de courant constant (SQ1), connectée par un raccordement au potentiel de service, est prévue comme unité de charge (ICSPG), que l'unité de comparaison (CSPG) est constituée d'une deuxième source de courant constant (SQ2) et d'un émetteur, ce dernier étant raccordé à la sortie de cette deuxième source de courant, d'un premier transistor (Q18), raccordé par son collecteur sur le potentiel de service, la base de ce transistor étant appliquée à une deuxième tension de référence (VF), ainsi que d'une première diode (Q19), raccordée également à la sortie de la deuxième source de courant constant (SQ2), cette diode étant branchée en série avec la première source de courant constant (SQ1).

3. Circuit selon la revendication 1
   **caractérisé par le fait**

   que l'unité de décharge (PWMS) est formée d'un étage différentiel (PWMS) avec deux transistors (Q28, Q29) couplés par leur émetteur et d'une troisième source de courant constant (SQ3), sur laquelle est raccordé en parallèle un transistor (Q31) qui fait partie d'un circuit miroir de courant (SS), l'anode d'une deuxième diode (Q32) et une résistance (RUe) étant placées à la base du transistor (Q31) du circuit miroir de courant (SS) et qu'une valeur de commande (Ue), qui contrôle le transistor (Q31) du circuit miroir de courant (SS), est appliquée à la résistance (RUe).

4. Circuit selon une des revendications précédentes
   **caractérisé par le fait**

   que la valeur de commande (Ue) est la tension d'entrée.

5. Circuit selon une des revendications précédentes
   **caractérisé par le fait**

   que la décharge de l'élément de stockage (C2) et d'une autre unité de stockage (C1), qui agit sur la fréquence de répétition (VCOfx) de l'oscillateur (VCO), est initiée par deux étages à bascules (FF1, FF2), qui s'excitent en série, la première bascule (FF2) étant placée dans l'unité de commande (FFPWM) du modulateur d'impulsions en largeur (PWM) et une autre bascule (FF1) étant placée dans l'oscillateur (VCO).

6. Circuit selon une des revendications précédentes
   **caractérisé par le fait**

   que le rapport impulsion/pause (DR) du signal de commutation (Up) est réglable indépendamment de la fréquence maximum de répétition (VCOfmax) de l'oscillateur (VCO).

7. Circuit selon une des revendications précédentes
   **caractérisé par le fait**

   que les unités de stockage (C1, C2) sont des condensateurs.

8. Circuit selon une des revendications précédentes
   **caractérisé par le fait**

   que, lors de la diminution de la fréquence de répétition (VCOfx) de l'oscillateur à commande par la tension (VCO), l'impédance d'entrée des circuits en aval est adaptée.

9. Circuit selon une des revendications précédentes
   **caractérisé par le fait**

   que les transistors travaillent en service non saturé.

10. Circuit selon une des revendications précédentes
    **caractérisé par le fait**

    qu'il travaille avec des courants compensés en température.

11. Circuit selon une des revendications précédentes
    **caractérisé par le fait**

que celui-ci peut être intégré sur un composant en technique à logique ECL et en technique des circuits à sources de courant.

FIG 1

FIG 2a $U_T$ $T_{min}$

FIG 2b $U_P$ $t_{Emax}$

FIG 2c $U_P$

FIG 2d $U_T$ $T_y$ $t_{Ex}$

FIG 2e $U_P$ $t_{Ex}$

# FIG 3

EP 0 801 842 B1

FIG 4a
VCO fmax

FIG 4b
PG Vemax

FIG 4c
Up

FIG 4d
PG Vemin

FIG 4e
Up

EP 0 801 842 B1

FIG 4 f
VCO fx

FIG 4 g
PG Vemax

FIG 4 h
Up

FIG 4 i
PG Vemin

FIG 4 j
Up

EP 0 801 842 B1

FIG 5

EP 0 801 842 B1

FIG 6

FIG 7

FIG 8

FIG 9

23

EP 0 801 842 B1

FIG 10

V6
SPANNUNGSVERLAUF AN VCO
VF+18mV

SPANNUNGSVERLAUF AN CP6

SPANNUNGSVERLAUF AN MOSH

FIG 11

SPANNUNGSVERLAUF AN VCO
VF+18mV

SPANNUNGSVERLAUF AN CP6

SPANNUNGSVERLAUF AN MOSH

24

FIG 12

$t2_{opto/ireg}$
$t1_{opto/ireg}$
ton = tonmax
VG    VF

SPANNUNGSVERLAUF AN VCO
VF+18mV
SPANNUNGSVERLAUF AN CPG
VG
SPANNUNGSVERLAUF AN MOSH

FIG 13

0,08 ton
VG   VF

SPANNUNGSVERLAUF AN VCO

SPANNUNGSVERLAUF AN CPG

SPANNUNGSVERLAUF AN MOSH

t2PG